(19) Europäisches Patentamt
European Patent Office
Office européen des brevets

(11) **EP 2 730 684 A1**

(12) **EUROPEAN PATENT APPLICATION**
published in accordance with Art. 153(4) EPC

(43) Date of publication:
**14.05.2014 Bulletin 2014/20**

(51) Int Cl.:
*C25D 11/16* (2006.01)    *C25F 3/04* (2006.01)
*H01L 33/60* (2010.01)

(21) Application number: **12807272.5**

(22) Date of filing: **02.07.2012**

(86) International application number:
**PCT/JP2012/066895**

(87) International publication number:
**WO 2013/005717 (10.01.2013 Gazette 2013/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.07.2011   JP 2011148472**

(71) Applicant: **Fujifilm Corporation
Minato-ku
Tokyo 106-0031 (JP)**

(72) Inventors:
• **HATANAKA Yusuke
Haibara-gun
Shizuoka 421-0396 (JP)**
• **UESUGI Akio
Haibara-gun
Shizuoka 421-0396 (JP)**

(74) Representative: **HOFFMANN EITLE
Patent- und Rechtsanwälte
Arabellastrasse 4
81925 München (DE)**

(54) **INSULATING REFLECTIVE SUBSTRATE AND METHOD FOR PRODUCING SAME**

(57)    The purpose of the present invention is to provide an insulating reflective substrate which is capable of providing a light emitting element that has excellent insulating properties and excellent diffuse reflectance. An insulating reflective substrate of the present invention comprises an aluminum layer and an aluminum oxide layer that is provided on the surface of the aluminum layer. The aluminum oxide layer has a thickness from 80 $\mu$m to 300 $\mu$m (inclusive), and the aluminum oxide layer has large pits each having an opening in the surface of the aluminum oxide layer. The large pits have an average opening diameter of more than 1 $\mu$m but 30 $\mu$m or less and an average depth of 80 $\mu$m or more but less than the thickness of the aluminum oxide layer. The average distance between two large pits is 10 $\mu$m or more but less than the thickness of the aluminum oxide layer. The ratio of the total area of the openings of the large pits to the surface area of the aluminum oxide layer is from 10% to 40% (inclusive). Each large pit has small pits each having an opening in the inner surface of the large pit, and the small pits have an average opening diameter of 5-1,000 nm.

FIG.1

EP 2 730 684 A1

**Description**

TECHNICAL FIELD

The present invention relates to an insulating reflective substrate that may be used in a light-emitting device and more specifically to an insulating reflective substrate that may be used in a light-emitting diode (hereinafter referred to as "LED") and a method for manufacturing the same.

BACKGROUND ART

It is said that LEDs generally use as little as one-hundredth of the electricity consumed in fluorescent lamps and have a lifetime forty times longer than that of fluorescent lamps (40,000 hours). The characteristics including power saving and longer lifetime are important elements based on which LEDs are adopted in the environment-oriented society.
In particular, white LEDs also have merits including excellent color rendering properties and simpler power circuit than fluorescent lamps and therefore expectations are rising for their use in illumination light sources.
Recently, white LEDs with high luminous efficiency (30 to 150 Lm/W) required as the illumination light sources appeared on the market in succession and replaces fluorescent lamps (20 to 110 Lm/W) in the light use efficiency during practical use.
This sharply accelerated the trend for practical application of white LEDs instead of fluorescent lamps and there are an increasing number of cases where white LEDs are adopted for the backlight and illumination light source in liquid crystal display devices.
As a substrate that may be used in the white LEDs as described above, Patent Literature 1 describes "a light reflecting substrate comprising at least: an insulating layer; and a metal layer disposed in contact with the insulating layer, wherein the total reflectivity of light in the wavelength range of more than 320 nm and not more than 700 nm is not less than 50% and the total reflectivity of light in the wavelength range of 300 nm to 320 nm is not less than 60% (Claims 1 and 12).

CITATION LIST

PATENT LITERATURE

Patent Literature 1: WO 2010/150810

SUMMARY OF INVENTION

TECHNICAL PROBLEMS

The inventors of the invention have made a study on the light reflecting substrate described in Patent Literature 1 and as a result found that the light reflecting substrate has sufficient insulation properties and reflectance but the LED used may have a reduced diffuse reflectance depending on the surface profile of the aluminum substrate and be difficult to use in place of a fluorescent lamp.
Accordingly, the present invention aims at providing an insulating reflective substrate capable of providing a light-emitting device having both of excellent insulation properties and a high diffuse reflectance and a manufacturing method thereof, as well as a circuit board and the light-emitting device using the insulating reflective substrate.

SOLUTION TO PROBLEMS

The inventors of the invention have made an intensive study to achieve the above object and as a result found that excellent insulation properties and a high diffuse reflectance can be simultaneously achieved by using an aluminum oxide layer having specific large pits and small pits as an insulating layer, and the invention has been thus completed.
Specifically, the invention provides the following (1) to (8).
(1) An insulating reflective substrate comprising:

an aluminum layer and an aluminum oxide layer formed on a surface of the aluminum layer,
wherein the aluminum oxide layer has a thickness of 80 $\mu$m or more but up to 300 $\mu$m;
wherein the aluminum oxide layer has large pits whose openings are present at a surface of the aluminum oxide layer,
wherein the large pits have an average opening size of more than 1 μm but up to 30 μm,
wherein the large pits have an average depth of 80 μm or more but less than the thickness of the aluminum oxide layer,
wherein the large pits have an average distance therebetween of 10 μm or more but less than the thickness of the aluminum oxide layer,
wherein a ratio of a total area of the openings of the large pits to a surface area of the aluminum oxide layer is 10% or more but up to 40%,
wherein the large pits have small pits whose openings are present at inner surfaces of the large pits, and
wherein the small pits have an average opening size of 5 to 1,000 nm.

(2) The insulating reflective substrate according to (1), wherein a ratio between the thickness of the aluminum oxide layer and a thickness of the aluminum layer (aluminum oxide layer / aluminum layer) is from 0.6 to 5.0.

(3) The insulating reflective substrate according to (1) or (2), wherein the insulating reflective substrate is a substrate formed on a side of an LED light-emitting device on which light emission is observed.

(4) A method of manufacturing an insulating reflective substrate, comprising the step of:

subjecting a part of an aluminum substrate extending from its surface in a depth direction to anodizing treatment to obtain the insulating reflective substrate including an aluminum layer and an aluminum oxide layer formed on a surface of the aluminum layer,
wherein the aluminum layer is a remaining part of the aluminum substrate which did not undergo the anodizing treatment,
wherein the aluminum oxide layer is an anodized film formed from the aluminum substrate by the anodizing treatment,
wherein the aluminum substrate has a thickness of 80 μm or more,
wherein the aluminum substrate has large pits whose openings are present at the surface of the aluminum substrate,
wherein the large pits have an average opening size of more than 1 μm but up to 30 μm,
wherein the large pits have an average depth of 80 μm or more but less than the thickness of the aluminum substrate,
wherein the large pits have an average distance therebetween of 10 μm or more but less than the thickness of the aluminum substrate, and
wherein a ratio of a total area of the openings of the large pits to a surface area of the aluminum substrate is 10% or more.

(5) The method of manufacturing the insulating reflective substrate according to (4), wherein a ratio of a total thickness of the aluminum layer and the aluminum oxide layer to the thickness of the aluminum substrate is from 90 to 100%.

(6) The method of manufacturing the insulating reflective substrate according to (4) or (5), wherein the large pits are formed by subjecting the aluminum substrate to hydrochloric acid electrolysis.

(7) A circuit board comprising:

the insulating reflective substrate according to any one of (1) to (3); and
a metal interconnect layer formed on top of the insulating reflective substrate on a side on which an insulating layer is formed.

(8) A white LED light-emitting device comprising:

the circuit board according to (7);
a blue LED light-emitting device provided on top of the circuit board on a side on which the metal interconnect layer is formed; and
a fluorescent emitter provided at least on top of the blue LED light-emitting device.

ADVANTAGEOUS EFFECTS OF INVENTION

As will be described later, the invention can provide an insulating reflective substrate capable of providing a light-emitting device having both of excellent insulation properties and a high diffuse reflectance and a manufacturing method thereof, as well as a circuit board and the light-emitting device using the insulating reflective substrate.

Therefore, the light-emitting device of the invention can be advantageously used in place of a fluorescent lamp and is hence useful.

The method of manufacturing the insulating reflective substrate according to the invention is extremely useful because an aluminum oxide layer (anodized film) with a film thickness of about 100 $\mu$m can be formed in about 3 to 4 hours.

BRIEF DESCRIPTION OF DRAWINGS

[FIG. 1] FIG. 1 is a schematic partial cross-sectional view showing a preferred embodiment of an insulating reflective substrate of the invention.

[FIG. 2] FIG. 2 is a schematic view for calculating the average distance (L) between adjacent large pits.

[FIG. 3] FIG. 3 is a schematic partial cross-sectional view showing a preferred embodiment of an aluminum substrate.

[FIG. 4] FIG. 4 is a schematic view of an anodizing apparatus that may be used to perform anodizing treatment in the manufacture of the insulating reflective substrate of the invention.

[FIG. 5] FIG. 5 is a schematic cross-sectional view showing an example of the configuration of a white LED light-emitting device of the invention.

[FIG. 6] FIG. 6 is a graph showing an alternating current waveform that may be used to perform electrochemical graining treatment in the manufacture of an insulating reflective substrate in Comparative Example 3.

[FIG. 7] FIG. 7 is a schematic view showing a radial electrolytic cell in the electrochemical graining treatment with alternating current in the manufacture of the insulating reflective substrate in Comparative Example 3.

DESCRIPTION OF EMBODIMENTS

[Insulating Reflective Substrate]

Next, the insulating reflective substrate according to the invention is described in detail.

The insulating reflective substrate of the invention is an insulating reflective substrate including: an aluminum layer and an aluminum oxide layer formed on a surface of the aluminum layer, wherein the aluminum oxide layer has a thickness of 80 $\mu$m or more but up to 300 $\mu$m; wherein the aluminum oxide layer has large pits whose openings are present at a surface of the aluminum oxide layer, wherein the large pits have an average opening size of more than 1 $\mu$m but up to 30 $\mu$m, wherein the large pits have an average depth of 80 $\mu$m or more but less than the thickness of the aluminum oxide layer, wherein the large pits have an average distance therebetween of 10 $\mu$m or more but less than the thickness of the aluminum oxide layer, wherein a ratio of a total area of the openings of the large pits to a surface area of the aluminum oxide layer is 10% or more but up to 40%, wherein the large pits have small pits whose openings are present at inner surfaces of the large pits, and wherein the small pits have an average opening size of 5 to 1,000 nm.

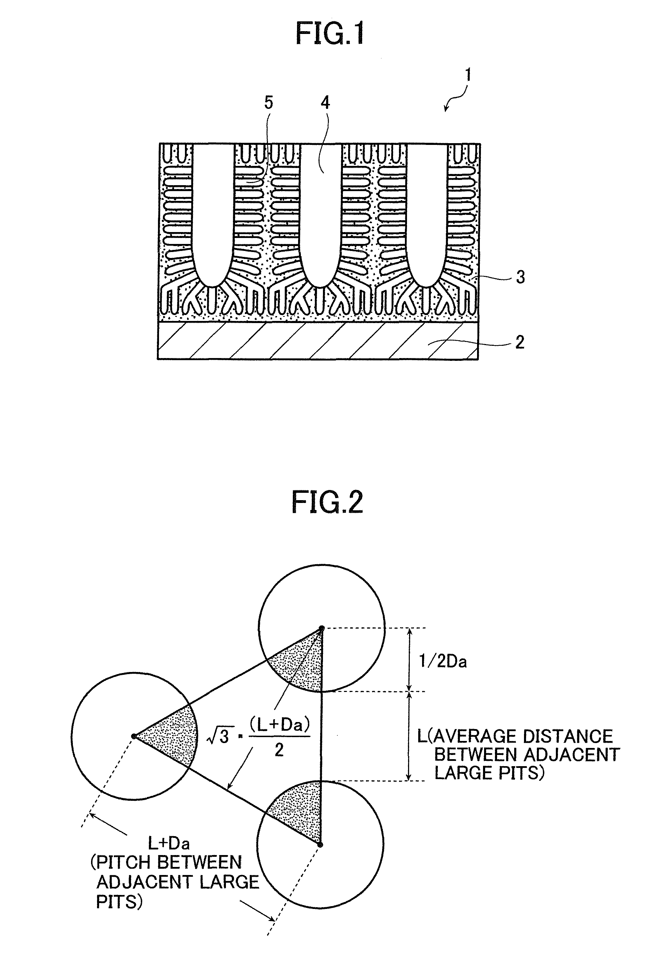

Next, the overall configuration of the insulating reflective substrate of the invention is described with reference to FIG. 1.

FIG. 1 is a schematic partial cross-sectional view showing a preferred embodiment of the insulating reflective substrate of the invention.

As shown in FIG. 1, an insulating reflective substrate 1 according to the invention includes an aluminum layer 2 and an aluminum oxide layer 3 formed on a surface of the aluminum layer 2.

As shown in FIG. 1, the aluminum oxide layer 3 also includes large pits 4 satisfying a specified average opening size and small pits 5 having their openings at a surface of the aluminum oxide layer 3 and inner surfaces of the large pits 4 and satisfying a specified average opening size.

The materials and the dimensions of the aluminum layer and the aluminum oxide layer are respectively described below in detail.

[Aluminum Layer]

The aluminum layer that may be used in the insulating reflective substrate of the invention is not particularly limited as long as it is a metal layer primarily composed of aluminum. However, the aluminum layer is preferably a remaining part of an aluminum substrate upon formation of the aluminum oxide layer through anodizing treatment on a part of the aluminum substrate extending from its surface in the depth direction in terms of preventing defects due to the formation of the aluminum oxide layer to be described later.

In the insulating reflective substrate of the invention, the thickness of the aluminum layer is not particularly limited and is preferably from 0.1 to 2.0 mm and more preferably from 0.2 to 1.0 mm.

The ratio between the thickness of the aluminum oxide layer to be described later and the thickness of the aluminum layer (aluminum oxide layer / aluminum layer) is preferably from 0.6 to 5.0 in terms of good withstand voltage (insulation properties) of a circuit board using the insulating reflective substrate of the invention and is more preferably from 1.0 to 2.0 in terms of good balance between the insulating properties and the thermal conductivity (heat dissipation properties).

[Aluminum Oxide Layer]

The aluminum oxide layer that may be used in the insulating reflective substrate of the invention is not particularly limited as long as it is an insulating layer primarily composed of aluminum oxide. However, as described above, the aluminum oxide layer is preferably an anodized film formed by anodizing a part of the aluminum substrate extending from its surface in the depth direction in terms of preventing defects due to the formation of the aluminum oxide layer.

In the insulating reflective substrate of the invention, the thickness of the aluminum oxide layer is 80 $\mu$m or more but up to 300 $\mu$m, preferably from 100 to 300 $\mu$m and more preferably from 100 to 200 $\mu$m.

The thickness of the aluminum oxide layer within the above-defined range is preferable because the circuit board using the insulating reflective substrate of the invention exhibits good insulation properties and the method of manufacturing the insulating reflective substrate according to the invention which will be described later has an obvious effect that the insulating reflective substrate can be formed in a period as short as about 3 to 4 hours.

<Large Pit>

The aluminum oxide layer has the large pits whose openings are present at the surface of the aluminum oxide layer (see reference numeral 4 of FIG. 1).

The large pits have an average opening size of more than 1 $\mu$m but up to 30 $\mu$m and preferably 2 to 20 $\mu$m in terms of the balance between the heat dissipation properties and the reflectance of a light-emitting device using the insulating reflective substrate of the invention.

The large pits have an average depth of 80 $\mu$m or more but less than the thickness of the aluminum oxide layer and preferably 150 $\mu$m or less.

The large pits have an average distance therebetween of 10 $\mu$m or more but less than the thickness of the aluminum oxide layer and preferably 30 $\mu$m or less.

The ratio of the total area of the openings of the large pits to the surface area of the aluminum oxide layer (hereinafter also referred to as "opening area ratio") is 10% or more but up to 40% and preferably 10% or more but up to 30% in terms of the balance between the heat dissipation properties and the reflectance of the light-emitting device using the insulating reflective substrate of the invention. It should be noted that the surface area of the aluminum oxide layer also includes the areas of the openings of the large pits.

The average opening size and the average depth of the large pits, the average distance therebetween and the opening area ratio thereof can be measured by observation with a field emission scanning electron microscope (FE-SEM). The same holds true for the large pits present in the aluminum substrate in the method of manufacturing the insulating reflective substrate of the invention to be described later.

More specifically, the large pits can be observed with FE-SEM (S-900 manufactured by Hitachi, Ltd.) according to the methods and conditions described below.

(Average Opening Size of Large Pits)

The display magnification was adjusted so that one or two visually discernible large pits were included in the display region of an image obtained by taking the surface of the aluminum oxide layer with FE-SEM; and the FE-SEM image was captured as digital data at the adjusted magnification and observed.

In a recess that can be identified as a large pit in the captured image, the edge of the pit was specified in the x and y directions; the opening size in each direction was calculated; and the average of the measurements in the x and y directions was taken as the opening size of the large pit.

This process was repeated to measure the opening size of 20 large pits and the average opening size of the large pits was calculated by the arithmetic mean operation.

(Average Depth of Large Pits)

The insulating reflective substrate was embedded in an embedding resin and polished to expose the cross-sectional surface.

The display magnification was adjusted so that at least 20 discernible large pits were included in the display region of an image obtained by taking the cross-sectional surface with FE-SEM; and the FE-SEM image was captured as digital data at the adjusted magnification and observed.

In the captured image, the depth of each large pit from its opening (surface of the aluminum oxide layer) was measured and the average depth of the large pits was calculated by the arithmetic mean operation.

(Average Distance between Adjacent Large Pits)

The display magnification was adjusted so that at least 20 discernible large pits were included in the display region of an image obtained by taking the surface of the aluminum oxide layer with FE-SEM; and the FE-SEM image was captured as digital data at the adjusted magnification and observed.

Then, as shown in the formula below, the pitch between adjacent large pits (L + Da) was arithmetically determined from the area of the taken image region and the number of measured large pits; and the average opening size (Da) of the large pits was subtracted from the pitch (L + Da) to determine the average distance (L) between adjacent large pits.

$$\text{Average distance (L) between adjacent large pits} = \{Sa / (Np \times 0.866)\}^{0.5} - Da$$

where Sa represents the area of the image region, Np represents the number of large pits in the image region, and Da represents the average opening size of the large pits.

To be more specific, this formula is derived as follows:

Assuming here that the large pits are closely packed, a specific triangle includes one-half of a large pit corresponding to shaded (hatched) portions as shown in FIG. 2.

The area St of the specific triangle is expressed by the following formula:

$$St = 1/2 \times (L + Da) \times \{\sqrt{3} \times (L + Da) / 2\}$$
$$= \sqrt{3} / 4 \times (L + Da)^2$$

Therefore, the number (Np) of the large pits present in the image region (area: Sa) is expressed by the following formula:

$$Np = Sa / (St \times 2) = Sa / [\{\sqrt{3}/4 \times (L + Da)^2\} \times 2]$$
$$= Sa \times 2 / \sqrt{3} \times (L + Da)^{-2}$$

The average distance (L) between adjacent large pits can be derived by deforming the above formula as follows:

$$(L + Da)^2 = Sa \times 2 / \sqrt{3} / Np$$

$$L + Da = \{Sa \times 2 / \sqrt{3} / Np\}^{0.5}$$

$$L = \{Sa \times 2 / \sqrt{3} / Np\}^{0.5} - Da$$
$$= \{Sa / (\sqrt{3} / 2 \times Np)\}^{0.5} - Da$$
$$= \{Sa / (0.866 \times Np)\}^{0.5} - Da$$

(Opening Area Ratio)

The image used to determine the average distance between adjacent large pits was used to calculate the opening area ratio using the following formula:

$$(\text{Opening area ratio}) = (\text{Np} \times 1/4 \times \text{Da}^2 \times \pi) \,/\, \text{Sa} \times 100 \;(\%)$$

where Np represents the number of large pits in the image region Da represents the average opening size of the large pits and Sa represents the area of the image region..

<Small Pit>

The large pits have small pits whose openings are present at the inner surfaces of the large pits (see reference numeral 5 of FIG. 1).

The small pits have an average opening size of 5 to 1,000 nm, preferably 10 to 100 nm, and more preferably 20 to 50 nm.

By having small pits with an average opening size as defined above at the inner surfaces of the large pits, the light-emitting device using the insulating reflective substrate of the invention has a good diffuse reflectance. This is presumably because the number of pores formed in a direction perpendicular to the plane of the substrate is extremely reduced to cause incident light to be more easily scattered.

In the insulating reflective substrate of the invention, not only the inner surfaces of the large pits 4 but also the surface of the aluminum oxide layer 3 may have the small pits as shown in FIG. 1.

(Average Opening Size of Small Pits)

The average opening size of the small pits can be measured by observation with a field emission scanning electron microscope (FE-SEM) similarly to that of the large pits.

More specifically, the display magnification was adjusted so that one or two visually discernible small pits were included in the display region of an image obtained by taking the surface of the aluminum oxide layer with FE-SEM; and the FE-SEM image was captured as digital data at the adjusted magnification and observed.

In a recess that can be identified as a small pit in the image, the edge of the pit was specified in the x and y directions; the opening size in each direction was calculated; and the average of the measurements in the x and y directions was taken as the opening size of the large pit.

This process was repeated to measure the opening size of 50 large pits and the average opening size of the small pits was calculated by the arithmetic mean operation.

[Method of Manufacturing Insulating Reflective Substrate]

The method of manufacturing the insulating reflective substrate according to the invention (hereinafter referred to simply as "manufacturing method of the invention") is described below in detail.

The manufacturing method of the invention includes the step of: subjecting a part of an aluminum substrate extending from its surface in the depth direction to anodizing treatment to obtain an insulating reflective substrate including an aluminum layer and an aluminum oxide layer formed on a surface of the aluminum layer, wherein the aluminum layer is a remaining part of the aluminum substrate which did not undergo the anodizing treatment, wherein the aluminum oxide layer is an anodized film formed from the aluminum substrate by the anodizing treatment, wherein the aluminum substrate has a thickness of 80 $\mu$m or more, wherein the aluminum substrate has large pits whose openings are present at the surface of the aluminum substrate, wherein the large pits have an average opening size of more than 1 $\mu$m but up to 30 $\mu$m, wherein the large pits have an average depth of 80 $\mu$m or more but less than the thickness of the aluminum substrate, wherein the large pits have an average distance therebetween of 10 $\mu$m or more but less than the thickness of the aluminum substrate, and wherein a ratio of a total area of the openings of the large pits to a surface area of the aluminum substrate is 10% or more.

The aluminum substrate, the anodizing treatment conditions and the like are described below in detail.

[Aluminum Substrate]

Any known aluminum substrate may be used as the aluminum substrate (starting material) for use in the manufacturing method of the invention. Illustrative examples include pure aluminum substrate; alloy plates composed primarily of aluminum and containing trace amounts of other elements; substrates made of low-purity aluminum (e.g., recycled material) on which high-purity aluminum has been vapor-deposited; substrates such as silicon wafers, quartz or glass whose surface has been covered with high-purity aluminum by a process such as vapor deposition or sputtering; and resin substrates on which aluminum has been laminated.

Other elements which may be present in the alloy plate include silicon, iron, copper, manganese, magnesium, chromium, zinc, bismuth, nickel and titanium. The content of other elements in the alloy is preferably not more than 10 wt%.

The composition or the preparation method (e.g., casting method) of the aluminum substrate as described above is not particularly limited and the composition, the preparation method and the like described in paragraphs [0031] to [0051] of Patent Literature 1 can be appropriately adopted.

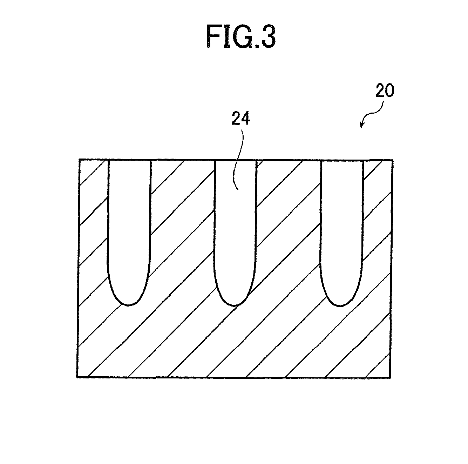

FIG. 3 is a schematic partial cross-sectional view showing a preferred embodiment of the aluminum substrate.

As shown in FIG. 3, an aluminum substrate 20 has large pits 24 whose openings are present at a surface of the aluminum substrate 20.

In the manufacturing method of the invention, the thickness of the aluminum substrate is not particularly limited and is at least 80 μm, preferably from about 0.1 to about 2 mm, more preferably from 0.15 to 1.5 mm and even more preferably from 0.2 to 1.0 mm based on the relation to the thicknesses of the aluminum oxide layer and the aluminum layer in the above-described insulating reflective substrate of the invention.

<Large Pit>

The aluminum substrate has large pits whose openings are present at the surface of the aluminum substrate (see reference numeral 24 of FIG. 3).

The large pits have an average opening size of more than 1 μm but up to 30 μm, and preferably 2 to 20 μm from the viewpoint that the electrolytic solution used in anodizing treatment to be described later permeates the interior of the pits to form small pits at the inner surfaces of the large pits.

The large pits have an average depth of 80 μm or more but less than the thickness of the aluminum substrate and preferably 150 μm or less.

The large pits have an average distance therebetween of 10 μm or more but less than the thickness of the aluminum substrate and preferably 30 μm or less in order to prevent defects due to the formation of the aluminum oxide layer formed by anodizing treatment to be described later, in other words, to prevent the aluminum substrate (aluminum) from remaining between the large pits.

The ratio of the total area of the openings of the large pits to the surface area of the aluminum substrate (hereinafter also referred to as "opening area ratio") is 10% or more, preferably 10% or more but up to 40%, and more preferably 10% or more but up to 30%. It should be noted that the surface area of the aluminum substrate also includes the areas of the openings of the large pits.

<Method of Forming Large Pits>

In the manufacturing method of the invention, the method of forming the large pits is not particularly limited and the large pits can be formed by, for example, subjecting the aluminum substrate to hydrochloric acid electrolysis using a direct current.

(Annealing Treatment)

The aluminum substrate is preferably crystallized by performing annealing treatment on the aluminum substrate as a pretreatment prior to the hydrochloric acid electrolysis.

The annealing treatment is not particularly limited and a preferred treatment involves baking the aluminum substrate at a temperature of 120 to 600°C.

The annealing treatment time varies with the baking temperature and is hence not particularly limited. The treatment time is preferably in a range of about 5 minutes to about 50 hours.

(Hydrochloric Acid Electrolysis)

The treatment conditions of the hydrochloric acid electrolysis are not particularly limited and the concentration of hydrochloric acid in the electrolytic solution is preferably from 0.2 to 30 g/L.

The electrolytic solution preferably has a temperature of 5 to 50°C.

In addition, the current density is preferably from 0.05 to 20 A/dm$^2$.

[Anodizing Treatment (Method of Forming Aluminum Oxide Layer and Small Pits)]

In the manufacturing method of the invention, the insulating reflective substrate having the aluminum layer and the aluminum oxide layer formed on its surface can be obtained by subjecting a part of the aluminum substrate extending from its surface in the depth direction to anodizing treatment.

The term "a part in the depth direction" is used herein to exclude the embodiment in which the whole depth is anodized, and the portion which is not anodized (the remaining part of the aluminum substrate) makes up the aluminum layer in the above-described insulating reflective substrate of the invention.

In the manufacturing method of the invention, the anodizing treatment may be performed by a method known in the art which is, for example, applied to the manufacture of a lithographic printing plate support or other process.

More specifically, the electrolytic solution that may be used in the anodizing treatment may contain acids such as sulfuric acid, phosphoric acid, chromic acid, oxalic acid, sulfamic acid, benzenesulfonic acid, amidosulfonic acid, malonic acid, citric acid, tartaric acid and boric acid, and hydroxides of alkali metals and alkaline-earth metals such as sodium hydroxide, magnesium hydroxide, potassium hydroxide, and calcium hydroxide. The acids and hydroxides may be used alone or in combination of two or more.

It is acceptable for ingredients ordinarily present in at least the aluminum substrate, electrodes, tap water, ground water and the like to be present in the electrolytic solution. In addition, secondary and tertiary ingredients may be added. Here, "secondary and tertiary ingredients" includes, for example, the ions of metals such as Na, K, Mg, Li, Ca, Ti, Al, V, Cr, Mn, Fe, Co, Ni, Cu and Zn; cations such as ammonium ion; and anions such as nitrate ion, carbonate ion, chloride ion, phosphate ion, fluoride ion, sulfite ion, titanate ion, silicate ion and borate ion. These may be present at concentrations of about 0 to 10,000 ppm.

In the manufacturing method of the invention, the anodizing treatment conditions vary depending on the electrolytic solution used, and thus cannot be strictly specified. However, it is generally suitable for the solution to have an electrolyte concentration of 1 to 80 wt% and a temperature of 5 to 70°C, and for the current density to be 0.5 to 60 A/dm$^2$, the voltage to be 1 to 600 V, and the electrolysis time to be 15 seconds to 20 hours. These conditions may be adjusted to obtain the desired anodized film weight (aluminum oxide layer thickness).

In addition, in the manufacturing method of the invention, methods described in, for example, JP 54-81133 A, JP 57-47894 A, JP 57-51289 A, JP 57-51290 A, JP 57-54300 A, JP 57-136596 A, JP 58-107498 A, JP 60-200256 A, JP 62-136596 A, JP 63-176494 A, JP 4-176897 A, JP 4-280997 A, JP 6-207299 A, JP 5-24377 A, JP 5-32083 A, JP 5-125597 A and JP 5-195291 A can also be used to perform the anodizing treatment.

In particular, as described in JP 54-12853 A and JP 48-45303 A, it is preferable to use a sulfuric acid solution as the electrolytic solution. The electrolytic solution has a sulfuric acid concentration of preferably 10 to 300 g/L, and an aluminum ion concentration of preferably 1 to 25 g/L and more preferably 2 to 10 g/L. Such an electrolytic solution can be prepared by adding a compound such as aluminum sulfate to dilute sulfuric acid having a sulfuric acid concentration of 50 to 200 g/L.

In the practice of the invention, when the anodizing treatment is carried out in an electrolytic solution containing sulfuric acid, direct current or alternating current may be applied across the aluminum substrate and the counter electrode.

When a direct current is applied to the aluminum substrate, the current density is preferably from 1 to 60 A/dm$^2$, and more preferably from 5 to 40 A/dm$^2$.

To keep burnt deposits from arising on portions of the aluminum substrate due to the concentration of current when the anodizing treatment is carried out as a continuous process in the manufacturing method of the invention, it is preferable to apply current at a low density of 5 to 10 A/dm$^2$ at the start of the anodizing treatment and to increase the current density to 30 to 50 A/dm$^2$ or more as the anodizing treatment proceeds. When the anodizing treatment is carried out as a continuous process, this is preferably done using a system that supplies power to the aluminum substrate through the electrolytic solution.

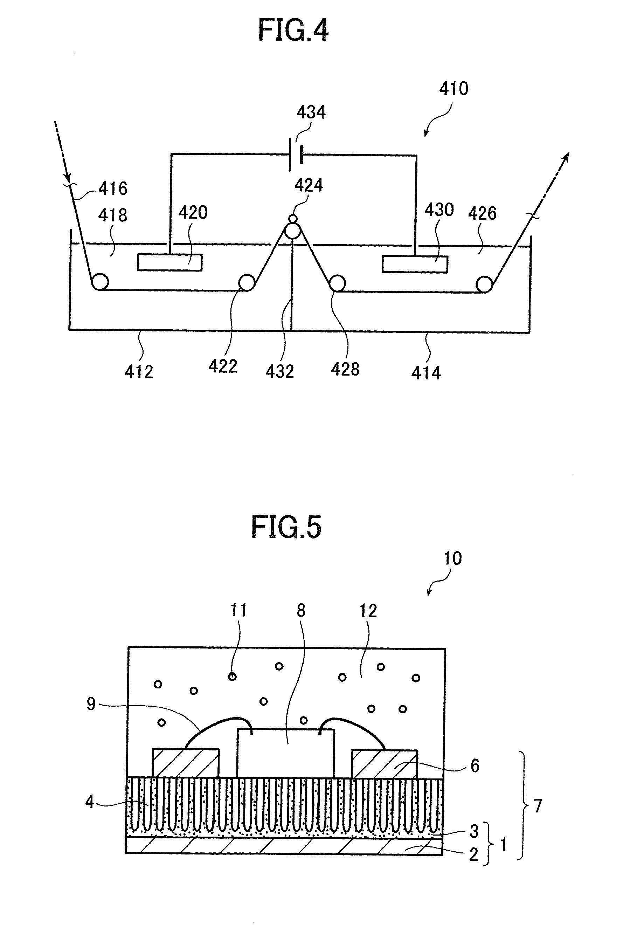

In addition, examples of electrolysis apparatuses that may be used in the anodizing treatment in the manufacturing method of the invention include those described in JP 48-26638 A, JP 47-18739 A and JP 58-24517 B. Of these, an apparatus like that shown in FIG. 4 is used with advantage.

FIG. 4 is a schematic view showing an exemplary apparatus for anodizing the surface of an aluminum substrate. In an anodizing apparatus 410, an aluminum substrate 416 is transported as shown by arrows in FIG. 4. The aluminum substrate 416 is positively (+) charged by a power supply electrode 420 in a power supply cell 412 containing an electrolytic solution 418. The aluminum substrate 416 is then transported upward by a roller 422 disposed in the power supply cell 412, turned downward on a nip roller 424 and transported toward an electrolytic cell 414 containing an electrolytic solution 426 to be turned to a horizontal direction by a roller 428. Then, the aluminum substrate 416 is negatively (-) charged by an electrolytic electrode 430 to form an anodized film on the substrate surface. The aluminum substrate 416 emerging from the electrolytic cell 414 is then transported to the section for the subsequent step. In the anodizing apparatus 410, the roller 422, the nip roller 424 and the roller 428 constitute direction changing means, and the aluminum substrate 416 is transported through the power supply cell 412 and the electrolytic cell 414 in a mountain shape and a reversed U shape by means of these rollers 422, 424 and 428. The power supply electrode 420 and the electrolytic electrode 430 are connected to a DC power supply 434.

The characteristic feature of the anodizing apparatus 410 shown in FIG. 4 is that the aluminum substrate 416 is transported in a mountain shape and a reversed U shape through the power supply cell 412 and the electrolytic cell 414 that are separated by a single cell wall 432. This configuration enables the length of the aluminum substrate 416 held in the two cells to be the shortest. Therefore, the total length of the anodizing apparatus 410 can be shortened, thus enabling a decrease in equipment costs. Transport of the aluminum substrate 416 in a mountain shape and a reversed U shape eliminates the necessity of forming an opening for passing the aluminum substrate 416 through the cell wall 432 between the cells 412 and 414. The amount of electrolytic solution required for maintaining each of the liquid surfaces of the cells 412 and 414 at a necessary height can be thus suppressed to enable a decrease in running costs.

In the manufacturing method of the invention, the anodizing treatment may be a single treatment under a set of treatment conditions but anodizing treatments under two or more different sets of conditions may be combined and sequentially carried out when the shape of the anodized film is to be controlled, for example, from place to place or in its depth direction.

In the manufacturing method of the invention, the anodizing treatment for forming small pits arranged in a honeycomb array is preferably carried out according to the methods described in, for example, JP 3,714,507 B, JP 2002-285382 A, JP 2006-124827 A, JP 2007-231339 A, JP 2007-231405 A, JP 2007-231340 A and JP 2007-238988 A because the total reflectance of the light-emitting device of the invention having the anodized film formed therein (insulation properties) is improved.

These treatments are preferably those described under the treatment conditions in the foregoing patent and published patent applications.

The insulating reflective substrate having the aluminum layer and the aluminum oxide layer formed on its surface can be manufactured by subjecting a part of the aluminum substrate extending from its surface in the depth direction to the above-described anodizing treatment.

As described above, the aluminum layer is the remaining part of the aluminum substrate which did not undergo the anodizing treatment, and the aluminum oxide layer is an anodized film formed from the aluminum substrate by the anodizing treatment.

By performing the anodizing treatment, the large pits of the aluminum substrate constitute large pits the aluminum oxide layer in the above-described insulating reflective substrate of the invention contains and in addition, small pits the aluminum oxide layer (large pits) in the above-described insulating reflective substrate of the invention contains are formed at the inner surfaces of the large pits.

In the manufacturing method of the invention, the ratio of the total thickness of the aluminum layer and the aluminum oxide layer to the thickness of the aluminum substrate (hereinafter also referred to as "retention rate") may be 90 to 100%.

This can be said to be an extremely excellent effect because when an aluminum substrate having no large pits is used, a treatment for a period of time as long as about 1,000 minutes or more is required to form an aluminum oxide layer having a thickness of about 100 $\mu$m but such a prolonged anodizing treatment may cause an anodized film formed at the initial stage to dissolve, and for this reason the total thickness of the aluminum layer and the aluminum oxide layer cannot be retained.

<Sealing Treatment>

In the method of manufacturing the insulating reflective substrate of the invention, when the aluminum oxide layer (anodized film) is porous, sealing treatment for sealing the small pits present in the film may be carried out in terms of the heat dissipation properties of the light-emitting device of the invention.

Sealing treatment may be carried out using any known method, illustrative examples of which include boiling water treatment, hot water treatment, steam treatment, sodium silicate treatment, nitrite treatment, and ammonium acetate treatment. Sealing treatment may be carried out by using the apparatuses and methods described in, for example, JP 56-12518 B, JP 4-4194 A, JP 5-202496 A and JP 5-179482 A.

<Rinsing Treatment>

In the method of manufacturing the insulating reflective substrate of the invention, each of the above-described treatments is preferably followed by rinsing with water. Water that may be used in rinsing includes pure water, well water and tap water. A nipping device may also be used to prevent the treatment solution from being carried over to the next step.

[Other Treatments]

In addition, in the manufacturing method of the insulating reflective substrate of the invention, the surface of the insulating reflective substrate can be optionally subjected to various treatments.

For example, an inorganic insulating layer made of a white insulating material such as titanium oxide or an organic insulating layer such as a white resist may be formed in order to enhance the whiteness (scattering properties) of the light-emitting device of the invention.

The insulating layer made of aluminum oxide may be colored by, for example, electrodeposition into a desired color instead of white. More specifically, coloring can be performed by electrolysis in an electrolytic solution containing color-stainable ion species as described in Anodization, edited by Metal Finishing Society of Japan, Metal Surface Technology Course B (1969, pp. 195-207) and New Alumite Theory, Kallos Publishing Co., Ltd. (1997, pp. 95-96), to be more specific, Co ion, Fe ion, Au ion, Pb ion, Ag ion, Se ion, Sn ion, Ni ion, Cu ion, Bi ion, Mo ion, Sb ion, Cd ion, As ion and the like.

For example, a layer according to a sol-gel process as described in paragraphs [0016] to [0035] of JP 6-35174 A can also be formed on an insulating layer also formed of an aluminum oxide layer in order to further enhance the insulation properties and high reflectivity.

The sol-gel process is a process which involves converting a sol generally made of a metal alkoxide into a gel having no fluidity through a hydrolytic polycondensation reaction and heating the gel to form an oxide layer (ceramic layer).

The metal alkoxide is not particularly limited and, from the viewpoint that a layer having a uniform thickness is formed, examples thereof include Al(O-R)n, Ba(O-R)n, B(O-R)n, Bi(O-R)n, Ca(O-R)n, Fe(O-R)n, Ga(O-R)n, Ge(O-R)n, Hf(O-R)n, In(O-R)n, K(OR)n, La(O-R)n, Li(O-R)n, Mg(O-R)n, Mo(O-R)n, Na(O-R)n, Nb(O-R)n, Pb(O-R)n, Po(O-R)n, Po(O-R)n, P(O-R)n, Sb(O-R)n, Si(O-R)n, Sn(OR)n, Sr(O-R)n, Ta(O-R)n, Ti(O-R)n, V(O-R)n, W(O-R)n, Y(O-R)n, Zn(O-R)n and Zr(O-R)n (where R represents a linear, branched or cyclic hydrocarbon group which may have a substituent and n represents an arbitrary natural number).

Of these, Si(O-R)n having high reactivity with the insulating layer and excellent formability of the sol-gel layer is more preferred.

In the practice of the invention, the method of forming the sol-gel layer is not particularly limited and a method which involves applying a sol solution and heating the applied solution is preferred in order to control the layer thickness.

The sol solution preferably has a concentration of 0.1 to 90 wt%, more preferably 1 to 80 wt% and most preferably 5 to 70 wt%.

Upon formation of the sol-gel layer in the invention, its thickness is preferably from 0.01 $\mu$m to 20 $\mu$m, more preferably from 0.05 $\mu$m to 15 $\mu$m and most preferably from 0.1 $\mu$m to 10 $\mu$m in terms of high reflectance and insulation properties. The sol solution may be repeatedly applied to increase the layer thickness.

[Circuit Board]

The circuit board of the invention is described below in detail.

The circuit board of the invention is a circuit board including the above-described insulating reflective substrate of the invention and a metal interconnect layer formed on top of the insulating reflective substrate on the side on which the aluminum oxide layer is formed.

The material of the metal interconnect layer is not particularly limited as long as it is an electrically conductive material, and specific examples thereof include gold (Au), silver (Ag), copper (Cu), aluminum (Al), magnesium (Mg) and nickel (Ni). These may be used alone or in combination of two or more thereof.

Of these, copper is preferably used because of its low electric resistance. A gold layer or a nickel/gold layer may be formed as the surface layer of the copper interconnect layer in order to enhance the ease of wire bonding.

In the circuit board of the invention, the metal interconnect layer preferably has a thickness of 0.5 to 1,000 $\mu$m, more preferably 1 to 500 $\mu$m and most preferably 5 to 250 $\mu$m in terms of conduction reliability and packaging compactness.

In the circuit board of the invention, the metal interconnect layer is preferably formed on top of the large pits of the aluminum oxide layer in the insulating reflective substrate of the invention because the metal interconnect layer has excellent interconnect adhesion.

In the practice of the invention, the method of forming the metal interconnect layer is not particularly limited and an exemplary method involves optionally forming a mask layer and thereafter carrying out, for example, any of various plating treatments such as electrolytic plating, electroless plating and displacement plating; sputtering; or vapor deposition.

[White LED Light-Emitting Device]

The light-emitting device of the invention is described below in detail.

The light-emitting device of the invention is a white LED light-emitting device including: the above-described circuit board of the invention, a blue LED light-emitting device provided on top of the circuit board on the side on which the metal interconnect layer is formed, and a fluorescent emitter provided at least on top of the blue LED light-emitting device.

The above-described circuit board of the invention can be used in various applications without any limitation on the shape of the light-emitting device used and the type of the LED.

Next, the configuration of the white LED light-emitting device of the invention is described with reference to FIG. 5.

FIG. 5 is a schematic cross-sectional view showing a preferred embodiment of the light-emitting device of the invention. The small pits (see reference numeral 5 in FIG. 1) are not shown in FIG. 5 because of scaling.

In a light-emitting device 10 shown in FIG. 5, a blue LED 8 is molded with a transparent resin 12 containing YAG fluorescent particles 11. Light excited by the YAG fluorescent particles 11 and afterglow of the blue LED 8 cause the light-emitting device to emit white light and the blue LED 8 is wire-bonded to a circuit board 7 of the invention having a metal interconnect layer 6 which also serves as an electrode for external connection.

The Blue LED shown in FIG. 5 which includes a light-emitting layer made of a semiconductor such as GaAlN, ZnS, ZnSe, SiC, GaP, GaAlAs, AlN, InN, AlInGaP, InGaN, GaN or AlInGaN formed on a substrate is used.

The semiconductor is, for example, of a homostructure, heterostructure or double heterostructure having an MIS junction, PIN junction or PN junction. The light-emitting wavelength may be variously selected in a range of ultraviolet light to infrared light depending on the material of the semiconductor layer and the mixture ratio thereof.

The material of the transparent resin shown in FIG. 5 is preferably a thermosetting resin.

At least one selected from the group consisting of epoxy resin, modified epoxy resin, silicone resin, modified silicone resin, acrylate resin, urethane resin and polyimide resin is preferably used as the themosetting resin. Epoxy resin, modified epoxy resin, silicone resin and modified silicone resin are particularly preferred.

The transparent resin is preferably hard in order to protect the blue LED.

A resin having excellent heat resistance, weather resistance and light resistance is preferably used for the transparent resin.

At least one selected from the group consisting of filler, diffusing agent, pigment, fluorescent material, reflective material, UV absorber and antioxidant may also be mixed into the transparent resin to impart predetermined functions thereto.

Furthermore, the fluorescent particles shown in FIG. 5 should be of a type capable of conversion of light absorbed from the blue LED to light having a different wavelength.

To be more specific, the fluorescent particles are made of, for example, nitride phosphors, oxynitride phosphors, SiAlON phosphors and $\beta$-SiAlON phosphors mainly activated by lanthanoid elements such as Eu and Ce; alkaline-earth halogen apatite phosphors, alkaline-earth metal borate halogen phosphors, alkaline-earth metal aluminate phosphors, alkaline-earth silicate phosphors, alkaline-earth sulfide phosphors, alkaline-earth thiogallate phosphors, alkaline-earth silicon nitride phosphors and germanate phosphors mainly activated by lanthanoid elements such as Eu and transition metal elements such as Mn; rare-earth aluminate phosphors and rare-earth silicate phosphors mainly activated by lanthanoid elements such as Ce; and organic complexes mainly activated by lanthanoid elements such as Eu. These may be used alone or in combination of two or more thereof.

On the other hand, the circuit board of the invention may also be used as a circuit board of a phosphor color mixed type white LED light-emitting device which uses a UV blue LED and a fluorescent emitter which absorbs light from the UV blue LED and emits fluorescence in a visible light region.

The fluorescent emitter absorbs blue light from the blue LED to emit fluorescence (yellow fluorescence) and the fluorescence and afterglow of the blue LED cause the light-emitting device to emit white light.

This is of a so-called "pseudo-white light-emitting type" which uses a blue LED chip as the light source and a yellow phosphor in combination. The circuit board of the invention may be used in the substrate of the light-emitting device in a light-emitting unit which uses other known light-emitting systems such as "UV near-UV light source type" which uses a UV near-UV LED chip as the light source and several types of red/green/blue phosphors in combination, and "RGB light source type" which emits white light from the three light sources of red, green and blue colors.

The method of mounting the LED device on the circuit board of the invention involves heating, and in the mounting method involving thermocompression bonding including reflow soldering and flip chip bonding, the maximum temperature reached is preferably from 220°C to 350°C, more preferably from 240°C to 320°C and most preferably from 260°C to 300°C in terms of uniform and reliable mounting.

The maximum temperature reached is preferably kept for 2 seconds to 10 minutes, more preferably 5 seconds to 5 minutes and most preferably 10 seconds to 3 minutes from the above viewpoint.

In order to prevent cracks from occurring in the anodized film due to a difference in the coefficient of thermal expansion between the metal substrate and the anodized film, a heat treatment may also be carried out before reaching the maximum temperature at a desired constant temperature for preferably 5 seconds to 10 minutes, more preferably 10 seconds to 5 minutes and most preferably 20 seconds to 3 minutes. The desired constant temperature is preferably from 80°C to 200°C, more preferably from 100°C to 180°C and most preferably from 120°C to 160°C.

The LED device is mounted by wire bonding at a temperature of preferably 80°C to 300°C, more preferably 90°C to 250°C and most preferably 100°C to 200°C in terms of reliable mounting. The heating time is preferably 2 seconds to 10 minutes, more preferably 5 seconds to 5 minutes and most preferably 10 seconds to 3 minutes.

EXAMPLES

The present invention is described below more specifically by way of examples. However, the present invention should not be construed as being limited to the following examples.

(Example 1)

<Preparation of Aluminum Substrate>

A melt was prepared from an aluminum alloy composed of 0.06 wt% silicon, 0.30 wt% iron, 0.005 wt% copper, 0.001 wt% manganese, 0.001 wt% magnesium, 0.001 wt% zinc and 0.03 wt% titanium, with the balance being aluminum and inevitable impurities. The aluminum alloy melt was subjected to molten metal treatment and filtration, then was cast into a 500 mm thick, 1,200 mm wide ingot by a direct chill casting process.

Then, the ingot was scalped with a scalping machine, removing on average 10 mm of material from the surface, then soaked at 550°C for about 5 hours. When the temperature had fallen to 400°C, the ingot was rolled with a hot rolling mill to a plate thickness of 2.7 mm.

In addition, heat treatment was carried out at 500°C without retention time in a continuous annealing machine, after which cold rolling was carried out at a temperature of 250°C or more to finish the aluminum plate to a thickness of 0.24 mm, thereby obtaining a JIS 1050 aluminum substrate.

The aluminum substrate was cut into a width of 1,030 mm, heated at 300°C for 1 hour and then subjected to the respective treatments described below.

<Formation of Large Pits>

The aluminum substrate was subjected to electrochemical graining treatment with a DC voltage to form large pits at a surface of the aluminum substrate.

More specifically, an aqueous solution containing 4.5 g/L of hydrochloric acid was used as the electrolytic solution at a temperature of 60°C and a carbon electrode was used as a counter electrode to treat the aluminum substrate for 10 minutes under such a condition that the current density in the constant current treatment was 3.8 A/dm$^2$.

The substrate was then rinsed by spraying with water.

<Formation of Small Pits (Anodizing Treatment>

The aluminum substrate having the large pits formed therein was subjected to constant voltage anodization with 70 g/L of a sulfuric acid electrolytic solution at 20°C and at a voltage of 15 V to change the aluminum up to the bottom of the formed large pits into an anodized film, thereby preparing an insulating reflective substrate having small pits at surfaces of the anodized film (including inner surfaces of the large pits).

It was determined from the current density during the anodizing treatment whether the aluminum substrate was completely changed into the anodized film. More specifically, the point at which the current density gradually reduced just after electrolysis reached a constant value was deemed as the "all change point." The (treatment) time required to reach the change point was as shown in Table 1.

<Shape Analysis>

The shape of the prepared insulating reflective substrate (thickness of the aluminum oxide layer, thickness of the aluminum layer, shape of the large pits and shape of the small pits) was observed from the front surface and fracture surface directions using FE-SEM (S-900 manufactured by Hitachi, Ltd.) at a magnification of 500X to 100X for the large pits and a magnification of 10,000X to 100,000X for the small pits. The results are shown in Table 1.

The ratio between the thicknesses of the respective layers (aluminum oxide layer / aluminum layer) and the retention rate [(thickness of aluminum oxide layer + thickness of aluminum layer) / thickness of aluminum substrate] were calculated. The results are shown in Table 1.

In Table 1-2, Opening area ratio of Large pit refers to a ratio of the total area of the openings of the large pits to the surface area of the aluminum oxide layer.

(Example 2)

Example 1 was repeated except that the temperature of the electrolytic solution used in the treatment for forming large pits was changed to 30°C, thereby preparing an insulating reflective substrate.

(Example 3)

Example 1 was repeated except that the treatment time in the treatment for forming large pits was changed to 20 minutes, thereby preparing an insulating reflective substrate.

(Example 4)

Example 1 was repeated except that in the treatment for forming small pits, anodizing treatment was carried out at a voltage of 25 V and a treatment temperature of 15°C, thereby preparing an insulating reflective substrate.

(Example 5)

Example 1 was repeated except that after the treatment for forming large pits but before the treatment for forming small pits, alkali etching treatment which involved immersing the aluminum substrate in sodium hydroxide (1% aqueous solution) at 60°C to dissolve 10 $g/m^2$ of material from the aluminum substrate was carried out to prepare an insulating reflective substrate.

(Comparative Example 1)

Example 1 was repeated except that the treatment for forming large pits was not carried out, thereby preparing an insulating reflective substrate.

(Comparative Example 2)

Example 1 was repeated except that the treatment for forming large pits was not carried out and the treatment for forming small pits was carried out until the same thickness as the thickness (120 $\mu$m) of the anodized film formed in Example 1 was obtained, thereby preparing an insulating reflective substrate.

(Comparative Example 3)

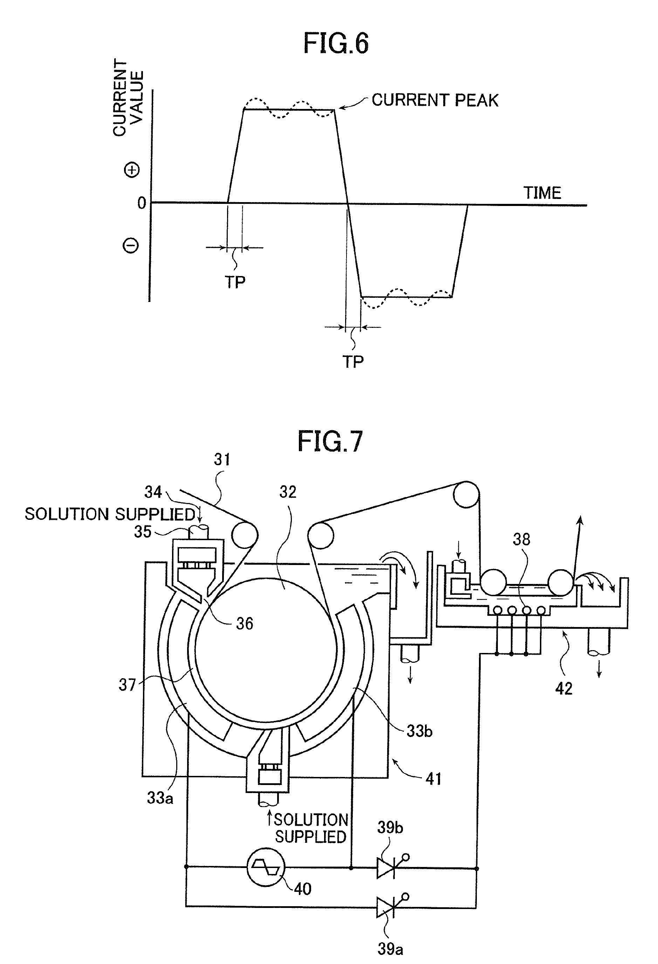

Example 1 was repeated except that the treatment for forming large pits was carried out under the conditions indicated below, thereby preparing an insulating reflective substrate.
More specifically, the aluminum substrate was subjected to continuous electrochemical graining treatment with an AC voltage at 60 Hz. The electrolytic solution was an aqueous solution containing 7.5 g/L of hydrochloric acid and 5 g/L of aluminum ions, and had a temperature of 35°C. The AC supply waveform was as shown in FIG. 6 and electrochemical graining treatment was carried out for a period of time TP until the current reached a peak from zero of 0.8 ms, at a duty ratio of 1:1, using an alternating current having a trapezoidal waveform, with a carbon electrode as the counter electrode. Ferrite was used for the auxiliary anode. An electrolytic cell of the type shown in FIG. 7 was used. The current density at the current peak was 25 $A/dm^2$. The amount of electricity, which is the total amount of electricity when the aluminum plate serves as an anode, was 300 $C/dm^2$. The substrate was then rinsed by spraying with water.

(Comparative Example 4)

Example 1 was repeated except that the treatment for forming small pits was carried out under the conditions indicated below, thereby preparing an insulating reflective substrate.
More specifically, the target aluminum substrate used as an anode was anodized in an aqueous ammonium borate solution (10%) used as an electrolytic solution at a cell temperature set to 90°C.
During the electrolysis, the treatment was carried out while stirring the cell at a constant current density of 1 $mA/cm^2$ until the voltage reached 100 V. After the voltage reached 100 V, the treatment was switched to constant voltage treatment for maintaining the voltage at 100 V and the constant voltage treatment was carried out for 30 minutes.

<Withstand Voltage (Insulation Properties>

The breakdown voltage (kV) of the prepared insulating reflective substrates was measured according to the JIS C2110 method. The results are shown in Table 1.

<Thermal Conductivity (Heat Dissipation Properties)>

The thermal conductivity of the resulting insulating substrates was measured with a laser flash thermal diffusivity measurement system TC-9000 manufactured by ULVAC-RIKO, Inc. according to the t1/2 method. The results are shown in Table 1.
Samples having a thermal conductivity of about 10 W/mK or more can be evaluated as having excellent heat dissipation properties.

(Reflectance)

The total reflectance (overall average in SPIN mode) and the diffuse reflectance (overall average in SPEX mode) at 400 to 700 nm of the prepared insulating reflective substrates were measured using a SP-64 integrating sphere photometer manufactured by X-Rite, incorporated. The results are shown in Table 1.

[Table 1]

| Table 1-1 | | | | | |
|---|---|---|---|---|---|
| | Aluminum substrate | Aluminum oxide layer | Aluminum layer (Remaining part of aluminum substrate) | Ratio | Retention rate |
| | Thickness ($\mu$m) | Thickness ($\mu$m) | Thickness ($\mu$m) | (Aluminum oxide layer / aluminum layer) | (%) |
| Example 1 | 240 | 120 | 118 | 1.0 | 99 |
| Example 2 | 240 | 105 | 135 | 0.8 | 100 |
| Example 3 | 240 | 160 | 68 | 2.4 | 95 |
| Example 4 | 240 | 120 | 96 | 1.3 | 90 |
| Example 5 | 240 | 80 | 150 | 0.5 | 96 |
| Comparative Example 1 | 240 | 15 | 223 | 0.1 | 99 |
| Comparative Example 2 | 240 | 120 | 60 | 2.0 | 75 |
| Comparative Example 3 | 240 | 120 | 118 | 1.0 | 99 |
| Comparative Example 4 | 240 | 120 | 118 | 1.0 | 99 |

[Table 2]

| Table 1-2 | | | | | | |
|---|---|---|---|---|---|---|
| | Large pit | | | | Small pit | |
| | Average opening size ($\mu$m) | Average depth ($\mu$m) | Average distance between adjacent pits ($\mu$m) | Opening area ratio (%) | Average opening size (nm) | Time required (min.) |
| Example 1 | 27 | 100 | 15 | 25 | 15 | 220 |
| Example 2 | 20 | 85 | 20 | 19 | 15 | 200 |
| Example 3 | 28 | 142 | 16 | 27 | 15 | 220 |
| Example 4 | 27 | 100 | 15 | 25 | 30 | 260 |
| Example 5 | 30 | 60 | 15 | 34 | 30 | 260 |

(continued)

| Table 1-2 | | | | | | |
|---|---|---|---|---|---|---|
| | Large pit | | | | Small pit | |
| | Average opening size (μm) | Average depth (μm) | Average distance between adjacent pits (μm) | Opening area ratio (%) | Average opening size (nm) | Time required (min.) |
| Comparative Example 1 | - | - | - | - | 15 | 220 |
| Comparative Example 2 | - | - | - | - | 17 | 1200 |
| Comparative Example 3 | 35 | 40 | 40 | 60 | 15 | 220 |
| Comparative Example 4 | 27 | 100 | 15 | 25 | - | 40 |

[Table 3]

| Table 1-3 | | | | |
|---|---|---|---|---|
| | Withstand voltage (kV) | Thermal conductivity (W/mK) | Total reflectance (%) | Diffuse reflectance (%) |
| Example 1 | 6.0 | 11.0 | 86 | 86 |
| Example 2 | 5.0 | 15.0 | 87 | 86 |
| Example 3 | 7.8 | 10.0 | 84 | 82 |
| Example 4 | 6.5 | 12.0 | 85 | 84 |
| Example 5 | 4.5 | 18.0 | 88 | 87 |
| Comparative Example 1 | 0.8 | 20.0 | 90 | 66 |
| Comparative Example 2 | 6.0 | 4.0 | 88 | 65 |
| Comparative Example 3 | 6.0 | 11. 0 | 80 | 55 |
| Comparative Example 4 | 6.0 | 11.0 | 80 | 70 |

The results shown in Table 1 revealed that the insulating reflective substrate in which the aluminum oxide layer has no large pit has a low withstand voltage, poor insulation properties and also a low diffuse reflectance when the thickness of the aluminum oxide layer is small (Comparative Example 1). It was also revealed that the heat dissipation properties are poor and the diffuse reflectance is low even when the thickness of the aluminum oxide layer is approximately the same as that in Examples (Comparative Example 2). On the other hand, it was revealed that even when the aluminum oxide layer has large pits, the average opening size of the large pits is large, and when the average depth is small, the reflectance (in particular the diffuse reflectance) is reduced (Comparative Example 3), and that the reflectance (in particular the diffuse reflectance) is reduced also when the aluminum oxide layer does not have small pits (Comparative Example 4).

In contrast, it was revealed that the insulating reflective substrates which have specified large pits and small pits in the aluminum oxide layer each have a high withstand voltage and good insulation properties and also have a high reflectance (in particular a high diffuse reflectance), and that the light-emitting devices using the substrates are all useful as substitutes for fluorescent lamps (Examples 1 to 5).

It was revealed that, of Examples 1 to 5, Examples 1 to 4 in which the ratio between the thickness of the aluminum oxide layer and the thickness of the aluminum layer (aluminum oxide layer / aluminum layer) is in a range of 0.6 to 5.0 exhibit excellent insulation properties.

In particular, the comparison between Example 1 and Comparative Example 2 revealed that, in Example 1, not only is the diffuse reflectance excellent but the time required for anodizing treatment is also considerably reduced by using an aluminum substrate having large pits previously formed therein in the case of forming an aluminum oxide layer having the same film thickness.

DESCRIPTION OF SYMBOLS

| | |
|---|---|
| 1 | insulating reflective substrate |
| 2 | aluminum layer |
| 3 | aluminum oxide layer |
| 4 | large pit |
| 5 | small pit |
| 6 | metal interconnect layer |
| 7 | circuit board |
| 8 | blue LED |
| 9 | wire |
| 10 | light-emitting device |
| 11 | fluorescent particle |
| 12 | transparent resin |
| 20 | aluminum substrate |
| 24 | large pit |
| 31 | aluminum foil |
| 32 | radial drum roller |
| 33a, 33b | main electrode |
| 34 | electrolytic treatment solution |
| 35 | electrolytic solution feed inlet |
| 36 | slit |
| 37 | electrolytic solution channel |
| 38 | auxiliary anode |
| 39a, 19b | thyristor |
| 40 | AC power supply |
| 41 | main electrolytic cell |
| 42 | auxiliary anode cell |
| 410 | anodizing apparatus |
| 412 | power supply cell |
| 414 | electrolytic cell |
| 416 | aluminum substrate |
| 418, 426 | electrolytic solution |
| 420 | power supply electrode |
| 422, 428 | roller |
| 424 | nip roller |
| 430 | electrolytic electrode |
| 432 | cell wall |
| 434 | DC power supply |

**Claims**

1. An insulating reflective substrate comprising:

   an aluminum layer and an aluminum oxide layer formed on a surface of the aluminum layer,
   wherein the aluminum oxide layer has a thickness of 80 $\mu$m or more but up to 300 $\mu$m;
   wherein the aluminum oxide layer has large pits whose openings are present at a surface of the aluminum oxide layer,

wherein the large pits have an average opening size of more than 1 µm but up to 30 µm,

wherein the large pits have an average depth of 80 µm or more but less than the thickness of the aluminum oxide layer,

wherein the large pits have an average distance therebetween of 10 µm or more but less than the thickness of the aluminum oxide layer,

wherein a ratio of a total area of the openings of the large pits to a surface area of the aluminum oxide layer is 10% or more but up to 40%,

wherein the large pits have small pits whose openings are present at inner surfaces of the large pits, and

wherein the small pits have an average opening size of 5 to 1,000 nm.

2. The insulating reflective substrate according to claim 1, wherein a ratio between the thickness of the aluminum oxide layer and a thickness of the aluminum layer (aluminum oxide layer / aluminum layer) is from 0.6 to 5.0.

3. The insulating reflective substrate according to claim 1 or 2, wherein the insulating reflective substrate is a substrate formed on a side of an LED light-emitting device on which light emission is observed.

4. A method of manufacturing an insulating reflective substrate, comprising the step of:

subjecting a part of an aluminum substrate extending from its surface in a depth direction to anodizing treatment to obtain the insulating reflective substrate including an aluminum layer and an aluminum oxide layer formed on a surface of the aluminum layer,

wherein the aluminum layer is a remaining part of the aluminum substrate which did not undergo the anodizing treatment,

wherein the aluminum oxide layer is an anodized film formed from the aluminum substrate by the anodizing treatment,

wherein the aluminum substrate has a thickness of 80 µm or more,

wherein the aluminum substrate has large pits whose openings are present at the surface of the aluminum substrate,

wherein the large pits have an average opening size of more than 1 µm but up to 30 µm,

wherein the large pits have an average depth of 80 µm or more but less than the thickness of the aluminum substrate,

wherein the large pits have an average distance therebetween of 10 µm or more but less than the thickness of the aluminum substrate, and

wherein a ratio of a total area of the openings of the large pits to a surface area of the aluminum substrate is 10% or more.

5. The method of manufacturing the insulating reflective substrate according to claim 4, wherein a ratio of a total thickness of the aluminum layer and the aluminum oxide layer to the thickness of the aluminum substrate is from 90 to 100%.

6. The method of manufacturing the insulating reflective substrate according to claim 4 or 5, wherein the large pits are formed by subjecting the aluminum substrate to hydrochloric acid electrolysis.

7. A circuit board comprising:

the insulating reflective substrate according to any one of claims 1 to 3; and

a metal interconnect layer formed on top of the insulating reflective substrate on a side on which an insulating layer is formed.

8. A white LED light-emitting device comprising:

the circuit board according to claim 7;

a blue LED light-emitting device provided on top of the circuit board on a side on which the metal interconnect layer is formed; and

a fluorescent emitter provided at least on top of the blue LED light-emitting device.

# FIG.1

# FIG.2

$$\sqrt{3} \cdot \frac{(L+Da)}{2}$$

1/2Da

L(AVERAGE DISTANCE BETWEEN ADJACENT LARGE PITS)

L+Da
(PITCH BETWEEN ADJACENT LARGE PITS)

# FIG.3

# FIG.4

# FIG.5

# FIG.6

# FIG.7

## INTERNATIONAL SEARCH REPORT

| | International application No. |
|---|---|
| | PCT/JP2012/066895 |

A.  CLASSIFICATION OF SUBJECT MATTER
*C25D11/16*(2006.01)i, *C25F3/04*(2006.01)i, *H01L33/60*(2010.01)i

According to International Patent Classification (IPC) or to both national classification and IPC

B.  FIELDS SEARCHED

Minimum documentation searched (classification system followed by classification symbols)
C25D11/16, C25F3/04, H01L33/60

Documentation searched other than minimum documentation to the extent that such documents are included in the fields searched
Jitsuyo Shinan Koho        1922-1996    Jitsuyo Shinan Toroku Koho    1996-2012
Kokai Jitsuyo Shinan Koho   1971-2012    Toroku Jitsuyo Shinan Koho    1994-2012

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | WO 2010/150810 A1  (Fujifilm Corp.), 29 December 2010 (29.12.2010), paragraphs [0060] to [0075], [0089] to [0099]; claims & WO 2010/150810 A1     & TW 201107797 A | 1-8 |
| A | JP 9-304938 A  (Konica Corp.), 28 November 1997 (28.11.1997), paragraphs [0029] to [0043]; fig. 1 (Family: none) | 1-8 |
| A | JP 2000-349320 A  (Kobe Steel, Ltd.), 15 December 2000 (15.12.2000), entire text (Family: none) | 1-8 |

☐  Further documents are listed in the continuation of Box C.        ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 24 July, 2012 (24.07.12) | 31 July, 2012 (31.07.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010150810 A
- JP 54081133 A
- JP 57047894 A
- JP 57051289 A
- JP 57051290 A
- JP 57054300 A
- JP 57136596 A
- JP 58107498 A
- JP 60200256 A
- JP 62136596 A
- JP 63176494 A
- JP 4176897 A
- JP 4280997 A
- JP 6207299 A
- JP 5024377 A
- JP 5032083 A
- JP 5125597 A
- JP 5195291 A
- JP 54012853 A
- JP 48045303 A
- JP 48026638 A
- JP 47018739 A
- JP 58024517 B
- JP 3714507 B
- JP 2002285382 A
- JP 2006124827 A
- JP 2007231339 A
- JP 2007231405 A
- JP 2007231340 A
- JP 2007238988 A
- JP 56012518 B
- JP 4004194 A
- JP 5202496 A
- JP 5179482 A
- JP 6035174 A

**Non-patent literature cited in the description**

- *Metal Finishing Society of Japan, Metal Surface Technology Course B,* 1969, 195-207
- New Alumite Theory. Kallos Publishing Co., Ltd, 1997, 95-96